# FASCICULE DE BREVET EUROPEEN

(11) **EP 3 154 118 B1**
(45) Date de publication et mention de la délivrance du brevet: **27.02.2019**
(21) Numéro de dépôt: 15306566.9
(22) Date de dépôt: 06.10.2015
(51) Int. Cl.: G01R 31/44, H01M 10/42, G01R 31/36, H01M 10/48, H05K 5/06

(54) **DISPOSITIF ATEX DE CONTROLE ET DE GESTION D'AU MOINS UN ENSEMBLE D'ELEMENTS CONSTITUTIFS DE BATTERIE D'ACCUMULATEURS**
ATEX-VORRICHTUNG ZUR KONTROLLE UND VERWALTUNG MINDESTENS EINER GESAMTHEIT VON BESTANDTEILEN EINER BATTERIE AUS AKKUMULATOREN
ATEX DEVICE FOR MONITORING AND MANAGING AT LEAST ONE SET OF ELEMENTS THAT MAKE UP A BATTERY

(43) Date de publication de la demande: 12.04.2017
(73) Titulaire: Vertiv Industrial Systems S.A.S., 69680 Chassieu (FR)
(72) Inventeur: QUEYROI, Pierre, 38460 SAINT ROMAIN DE JALIONAS (FR); PERRIN, Michaël, 69500 BRON (FR)
(74) Mandataire: Cabinet Laurent & Charras

(56) Documents cités:
- EP-A1- 0 764 851
- WO-A1-2014/028420
- CN-A- 102 522 791
- CN-U- 204 303 941
- FR-A1- 2 759 845
- FR-A1- 2 867 837
- US-A1- 2008 309 469

## Description

### DOMAINE TECHNIQUE

La présente invention concerne le domaine technique des systèmes de contrôle et de gestion de batteries d'accumulateurs (de l'anglais « *Battery Monitoring System* », ou « BMS ») permettant le contrôle et la gestion des différents éléments d'une batterie d'accumulateurs. Elle s'applique plus particulièrement dans le domaine des dispositifs dits « ATEX », c'est-à-dire en milieu déflagrant ou explosif.

### ART ANTERIEUR

Il existe, dans l'état de la technique, des applications dans lesquelles il est nécessaire de mettre en oeuvre des armoires électriques aptes à résister aux milieux à risques, notamment à atmosphère explosive, dites ATEX, et renfermant une pluralité de batteries d'accumulateurs.

Par milieux à risques, on entend notamment les milieux, principalement industriels, présentant des risques d'incendies, d'explosions et/ou de chocs électriques. Une atmosphère explosive est une atmosphère qui pourrait devenir explosive en raison des conditions locales et/ou opérationnelles. C'est un mélange d'air et de substances inflammables sous forme de gaz, vapeurs, brouillards ou poussières, dans lequel, après inflammation, la combustion se propage à l'ensemble du mélange non brûlé.

Lorsqu'il est nécessaire de vérifier la charge ou l'état des différents éléments constitutifs des batteries, il est connu d'utiliser des dispositifs de contrôle et de gestion desdites batteries, dits BMS. Ces dispositifs BMS sont des systèmes électroniques se présentant sous la forme d'un boitier simple comprenant, d'une manière générale, une carte électronique apte à mesurer les différents paramètres utiles des batteries, tels que tension, impédance, température, etc...

Cependant, les dispositifs BMS de l'état de la technique ne sont pas conçus selon la réglementation ATEX, de sorte qu'ils ne peuvent pas être montés au niveau de l'armoire ATEX en tant que telle, mais doivent plutôt être installés hors de la zone à risque.

Il est ainsi nécessaire de dérouler des longueurs de câbles, notamment un câble par élément de batterie, hors de l'armoire ATEX pour venir se brancher sur le dispositif BMS en tant que tel. Il est bien évident que cette technique présente un inconvénient majeur lorsque l'armoire referme un nombre important de batteries d'accumulateurs.

### EXPOSE DE L'INVENTION

Ainsi donc, l'invention tend à proposer un dispositif de contrôle et de gestion d'au moins un ensemble d'éléments de batterie d'accumulateurs, destiné aux applications en milieux à risques, notamment à atmosphère explosive.

Un autre objectif de l'invention est de fournir un tel dispositif conforme à la certification IECex, laquelle certification procure un moyen pour les fabricants de matériels ATEX d'obtenir un certificat de conformité prévu pour être accepté dans les pays participants dans lesquels ce schéma de certification est reconnu.

Afin de résoudre les problèmes précités, il a été mis au point, selon l'invention, un dispositif de contrôle et de gestion d'au moins un ensemble d'éléments de batterie, remarquable en ce qu'il comprend un boîtier définissant une enceinte à atmosphère étanche et de sécurité augmentée, dans laquelle est agencée une carte électronique pour la mesure de tout paramètre utile relatif aux batteries d'accumulateurs. La carte électronique est encapsulée entre un polymère époxyde et le fond du boîtier, et comprend des moyens de connexion électrique aux batteries d'accumulateurs, au travers d'orifices ménagés dans le boîtier et recevant des presse-étoupes.

De cette manière, le dispositif de contrôle et de gestion selon l'invention peut être installé dans des zones à atmosphère explosive. Le boîtier à atmosphère étanche et de sécurité augmentée permet d'éviter la propagation d'un arc électrique ou d'une étincelle en zone dangereuse. Plus précisément, dans le cas par exemple, d'une armoire ATEX renfermant une pluralité de batteries d'accumulateurs, et installée dans une zone à risque, ledit dispositif selon l'invention peut être installé dans l'armoire en question, au plus près des batteries d'accumulateurs. Ainsi, chaque batterie peut être reliée au dispositif pour le contrôle et la gestion proprement dits, avec un seul et unique câble électrique, par exemple pour un ensemble de 20 éléments s'étendant hors de l'armoire électrique.

Un polymère époxyde est fabriqué par polymérisation d'une résine époxyde avec un durcisseur qui peut être, par exemple, à base d'anhydride d'acide, de phénol ou le plus souvent d'amine.

Selon une forme de réalisation particulière, les moyens de connexion électrique comprennent un bornier, de sorte que le BMS soit constitué de plusieurs boitiers en série (10 maximum).

Avantageusement, le boitier du dispositif selon l'invention comprend une ouverture ménagée, dans son épaisseur et en regard de la carte électronique pour permettre de visualiser l'état de fonctionnement de ladite carte électronique au travers du polymère époxyde.

Dans cette configuration, et selon une forme de réalisation plus spécifique, l'ouverture reçoit de manière étanche une lentille optique, et la carte électronique comprend une diode électroluminescente disposée en regard de ladite lentille optique pour signaler, par un signal visuel émis au travers de la lentille, l'état de fonctionnement de ladite carte électronique.

De préférence, le polymère époxyde utilisé est une colle bi-composant, constituée d'une résine époxyde et d'un agent polymérisant, par exemple le 1,4,7,10-tétraazadécane, commercialisée sous la marque déposée « Araldite ».

Le boitier est réalisé en toute matière appropriée pour être conforme à la réglementation ATEX, par exemple en polyester.

Selon une forme de réalisation particulière, le boîtier se présente sous la forme de deux compartiments entre lesquels sont agencés, un joint d'étanchéité de sécurité augmentée, et le polymère époxyde formant une capsule.

### BREVE DESCRIPTION DES DESSINS

D'autres caractéristiques et avantages de l'invention ressortiront clairement de la description qui en est réalisée ci-après, à titre indicatif et nullement limitatif, en référence aux figures annexées, dans lesquelles :
- la figure 1 est une représentation schématique en perspective éclatée d'un dispositif de contrôle et de gestion d'un ensemble d'éléments constituant une batterie d'accumulateurs selon l'invention ;
- la figure 2 est une représentation schématique en perspective du dispositif selon l'invention, privé de l'un de ses compartiments, notamment de celui qui ne comprend pas la carte électronique ;
- la figure 3 est une représentation schématique en perspective du dispositif selon l'invention.

### EXPOSE DETAILLE DE L'INVENTION

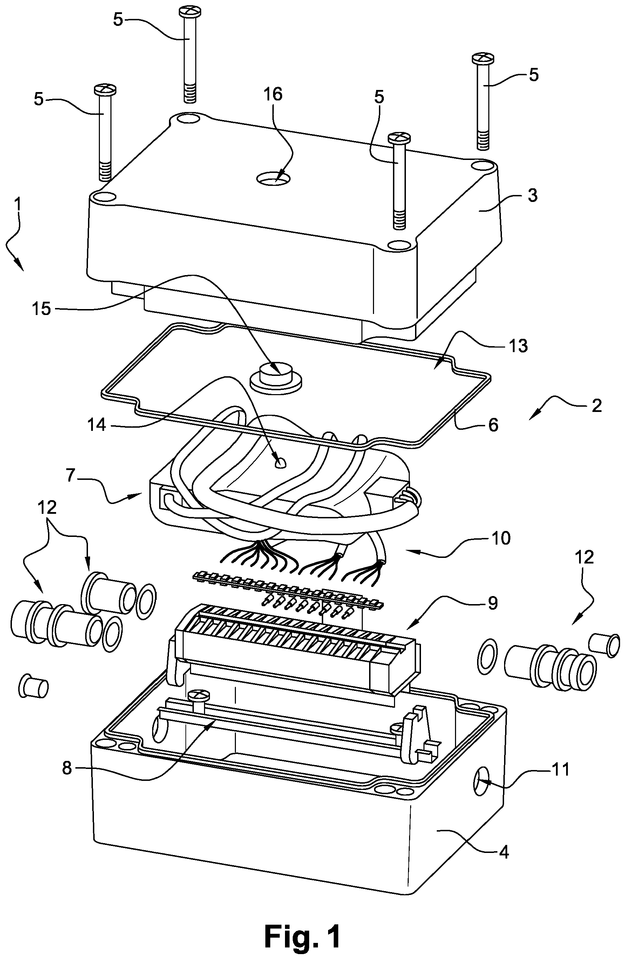

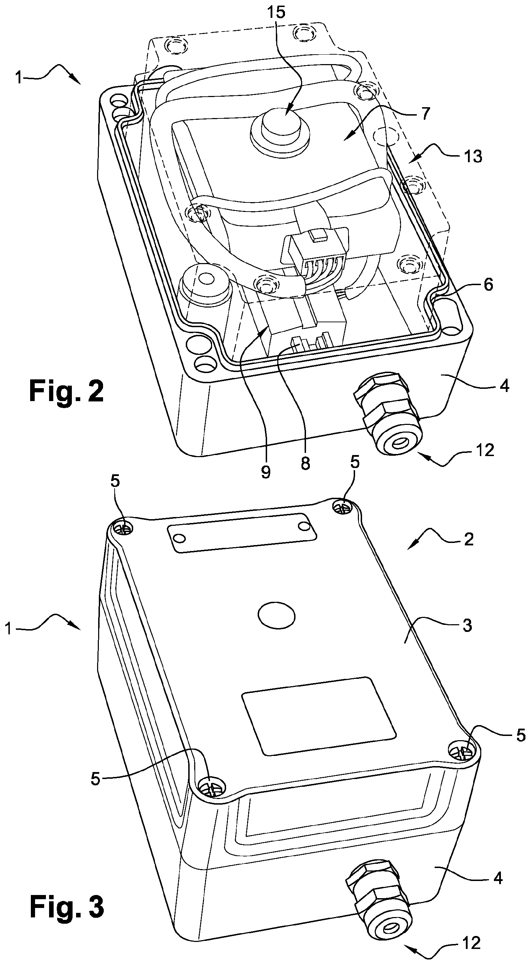

En référence aux figures 1 à 3, qui représentent un dispositif (1) de contrôle et de gestion d'un ensemble d'éléments constituant une de batterie d'accumulateurs (non représentées), notamment destiné aux applications en milieux à risques, celui-ci comprend un boîtier (2), par exemple en polyester, définissant une enceinte à atmosphère étanche et de sécurité augmentée.

Le boîtier (2) est, par exemple, parallélépipédique et comprend deux parties formant deux compartiments (3, 4) rendus solidaires l'un à l'autre par tous moyens appropriés, tels que par exemple par quatre vis (5) traversant les deux compartiments (3, 4) et agencées au quatre coin du parallélépipède. Pour assurer l'étanchéité, un joint d'étanchéité antidéflagrant (6) est prévu entre les deux compartiments (3, 4) du boîtier (2).

Le compartiment (3) du boîtier (2) forme un réceptacle pour une carte électronique (7) et le compartiment (4) forme un couvercle.

La carte électronique (7) agencée dans le compartiment (3) du boîtier (2) permet de mesurer et de calculer tous paramètres utiles relatifs aux batteries d'accumulateurs, tels que par exemple la température, l'impédance, la tension, etc.

Plus précisément, le compartiment (4) formant réceptacle comprend un rail de fixation (8) solidarisé, notamment par vissage au fond dudit compartiment (4). Le rail de fixation (8) reçoit un bornier de sécurité augmentée (9), permettant la connexion de la carte électronique (7) avec une pluralité de batteries d'accumulateurs. Le bornier (9) est donc connecté électriquement à la carte électronique (7) par l'intermédiaire de moyens de connexion (10) de tout type approprié et bien connus de l'état de la technique.

La carte électronique (7) est donc disposée dans le compartiment (3) formant réceptacle et sur le bornier (9). Le compartiment (4) comprend plusieurs orifices (11) pour permettre le passage de câbles électriques (non représentés) pour réaliser la connexion électrique entre les batteries d'accumulateurs à gérer, et la carte électronique (7). Ces orifices sont équipés de presse-étoupes (12) permettant d'assurer l'étanchéité entre l'extérieur et l'intérieur du boîtier (2), de manière à garantir une atmosphère étanche et de sécurité augmentée, et le respect de la norme ATEX du boîtier (2).

Un polymère époxyde (13), par exemple de la colle commercialisée sous la marque déposée « Araldite », est déposé pour venir coiffer le compartiment (3) et obturer son ouverture principale de manière à encapsuler la carte électronique (7), entre le fond dudit compartiment (3) et ledit polymère époxyde (13). Ce polymère époxyde (13) forme une capsule et assure l'étanchéité et une protection optimale de la carte électronique (7), de sorte à garantir le respect de la norme ATEX.

Le joint d'étanchéité de sécurité augmentée (6) est agencé tout autour de la périphérie de la capsule de polymère époxyde (13) pour réaliser la jointure entre les deux compartiments (3, 4) lorsque ceux-ci sont assemblés.

La carte électronique (7) présente, sur sa face en regard de la capsule de polymère époxyde (13), une diode électroluminescente (14) pour émettre un signal visuel qui est fonction de l'état de fonctionnement de ladite carte électronique (7). La capsule de polymère époxyde (13) comprend, quant à elle, une lentille (15) disposée sur sa face destinée à être en regard du compartiment (3) formant couvercle, et en regard de la diode électroluminescente (14). La lentille (15) est, par exemple, collée sur la capsule (13) et permet de focaliser la lumière émise par la diode électroluminescente (14) pour permettre de visualiser l'état de fonctionnement de ladite carte électronique (7), au travers de la capsule de polymère époxyde (13).

Le compartiment (3) formant couvercle comprend une ouverture (16) ménagée dans son épaisseur, en correspondance et de forme complémentaire à la lentille (15), de sorte que lorsque ledit compartiment (3) recouvre la capsule de polymère époxyde (13) et ferme le boîtier (2), la lentille (15) est visible par ladite ouverture (16). L'ouverture (16) du boîtier (2) reçoit notamment la lentille (15) d'une manière étanche pour assurer le respect de la norme ATEX.

Ainsi, il ressort de ce qui précède que l'invention fournit un dispositif (1) de contrôle et de gestion d'au moins un ensemble d'éléments constitutifs d'une batterie d'accumulateurs qui résiste aux incendies, explosions et/ou chocs électriques ou à tout autre risque pour répondre aux réglementations ATEX. Ainsi, un tel dispositif (1) peut être agencé directement au sein d'une armoire électrique, au plus près des batteries d'accumulateurs qu'elle renferme, et permet de simplifier le câblage de ladite armoire. Un seul câble électrique s'étend hors de l'armoire.

## Revendications

1. Dispositif (1) de contrôle et de gestion d'au moins un ensemble d'éléments constitutifs d'une batterie d'accumulateurs, ***caractérisé* en ce qu'**il comprend un boîtier (2) définissant une enceinte à atmosphère étanche et de sécurité augmentée, dans laquelle est agencée une carte électronique (7) pour la mesure de tout paramètre utile relatif aux batteries d'accumulateurs, ladite carte électronique (7) étant encapsulée entre un polymère époxyde (13) et le fond du boîtier (2), et **en ce qu'**il comprend des moyens (9) de connexion électrique aux batteries d'accumulateurs, au travers d'orifices (11) ménagés dans le boîtier (2) et recevant des presse-étoupes (12).

2. Dispositif (1) de contrôle et de gestion d'au moins un ensemble d'éléments constitutifs d'une batterie d'accumulateurs selon la revendication 1, ***caractérisé* en ce que** les moyens de connexion électrique comprennent un bornier (9).

3. Dispositif (1) de contrôle et de gestion d'au moins un ensemble d'éléments constitutifs d'une batterie d'accumulateurs selon l'une quelconque des revendications précédentes, ***caractérisé* en ce que** le boitier (2) comprend une ouverture (16) ménagée dans son épaisseur et en regard de la carte électronique (7) pour permettre de visualiser l'état de fonctionnement de ladite carte électronique (7) au travers du polymère époxyde (13).

4. Dispositif (1) de contrôle et de gestion d'au moins un ensemble d'éléments constitutifs d'une batterie d'accumulateurs selon la revendication 3, ***caractérisé* en ce que** l'ouverture (16) reçoit de manière étanche une lentille optique (15), et **en ce que** la carte électronique (7) comprend une diode électroluminescente (14) disposée en regard de ladite lentille optique (15) pour signaler, par un signal visuel émis au travers de la lentille (15), l'état de fonctionnement de ladite carte électronique (7).

5. Dispositif (1) de contrôle et de gestion d'au moins un ensemble d'éléments constitutifs d'une batterie d'accumulateurs selon l'une quelconque des revendications précédentes, ***caractérisé* en ce que** le boîtier (2) est réalisé en polyester.

6. Dispositif (1) de contrôle et de gestion d'au moins un ensemble d'éléments constitutifs d'une batterie d'accumulateurs selon l'une quelconque des revendications précédentes, ***caractérisé* en ce que** le boîtier (2) se présente sous la forme de deux compartiments (3, 4) entre lesquels sont agencés, un joint d'étanchéité antidéflagrant (6), et le polymère époxyde (13) formant une capsule.

## Patentansprüche

1. Vorrichtung (1) zur Kontrolle und Verwaltung mindestens einer Baugruppe von Bauteilen, die eine Akkumulatorbatterie bilden, ***dadurch gekennzeichnet, dass*** sie ein Gehäuse (2) umfasst, das einen Behälter mit gasdichter Atmosphäre und erhöhter Sicherheit definiert, in dem eine elektronische Platine (7) zur Messung aller nützlichen Parameter zu den Akkumulatorbatterien untergebracht ist, wobei diese elektronische Platine (7) zwischen einem Epoxidpolymer (13) und dem Gehäuseboden (2) eingekapselt ist, und ***dadurch, dass*** sie Mittel (9) zur elektrischen Verbindung mit den Akkumulatorbatterien enthält, über Öffnungen (11), ausgespart im Gehäuse (2) zur Aufnahme von Stopfbuchsen (12).

2. Vorrichtung (1) zur Kontrolle und Verwaltung mindestens einer Baugruppe von Bauteilen, die eine Akkumulatorbatterie bilden, nach Anspruch 1, ***dadurch gekennzeichnet, dass*** die elektrischen Verbindungsmittel eine Klemmenleiste (9) umfassen.

3. Vorrichtung (1) zur Kontrolle und Verwaltung mindestens einer Baugruppe von Bauteilen, die eine Akkumulatorbatterie bilden, nach einem der vorangehenden Ansprüche, ***dadurch gekennzeichnet, dass*** das Gehäuse (2) eine Öffnung (16) umfasst, ausgespart in seiner Dicke und gegenüber der elektronischen Platine (7), um eine Visualisierung des Betriebszustandes dieser elektronischen Platine (7) durch das Epoxidpolymer (13) zu ermöglichen.

4. Vorrichtung (1) zur Kontrolle und Verwaltung mindestens einer Baugruppe von Bauteilen, die eine Akkumulatorbatterie bilden, nach Anspruch 3, ***dadurch gekennzeichnet, dass*** in die Öffnung (16) in dichter Art und Weise eine optische Linse (15) eingesetzt wird und dass die elektronische Platine (7) eine Leuchtdiode (14) enthält, angeordnet gegenüber dieser optischen Linse (15) zur Signalisierung des Betriebes dieser elektronischen Platine (7) über ein visuelles Signal, das über die Linse (15) ausgegeben wird,

5. Vorrichtung (1) zur Kontrolle und Verwaltung mindestens einer Baugruppe von Bauteilen, die eine Akkumulatorbatterie bilden, nach einem der vorangehenden Ansprüche, ***dadurch gekennzeichnet, dass*** das Gehäuse (2) aus Polyester hergestellt wird.

6. Vorrichtung (1) zur Kontrolle und Verwaltung mindestens einer Baugruppe von Bauteilen, die eine Akkumulatorbatterie bilden, nach einem der vorangehenden Ansprüche, ***dadurch gekennzeichnet, dass*** das Gehäuse (2) die Form von zwei Abteilen (3, 4) hat, zwischen denen eine explosionsgeschützte Abdichtung (6) sowie das Epoxidpolymer (13) vorgesehen ist, die eine Kapsel bilden.

## Claims

1. Device (1) for monitoring and managing at least one set of elements constituting a set of batteries, ***characterized* by** the fact that it incorporates one casing (2) providing a sealed chamber with enhanced safety, in which an electronic circuit board (7) is installed for measuring whatever useful parameter pertaining to the battery sets, with the said electronic circuit board being encased between a polymer epoxide (13) and the bottom of the casing (2), and by the fact that it incorporates means (9) of electrical connection to the battery sets, through apertures (11) existing in the casing (2) and accommodating cable glands (12).

2. Device (1) for monitoring and managing at least one set of elements constituting a set of batteries in accordance with claim 1, ***characterized* by** the fact that the means of electrical connection includes a terminal plate (9).

3. Device (1) for monitoring and managing at least one set of elements constituting a set of batteries in accordance with any of the preceding claims, ***characterized* by** the fact that the casing (2) incorporates an opening (16) existing within its thickness, opposite the electronic circuit board (7) to enable one to view the state of operation of the said electronic circuit board (7) through the polymer epoxide (13).

4. Device (1) for monitoring and managing at least one set of elements constituting a set of batteries in accordance with claim 3, ***characterized* by** the fact that the opening (16) provides sealed accommodation for an optical lens (15), and by the fact that the electronic circuit board (7) incorporates a light-emitting diode (14) positioned opposite the said optical lens (15), to show the state of operation of the said electronic circuit board (7) through a visual signal emitted through the lens (15).

5. Device (1) for monitoring and managing at least one set of elements constituting a set of batteries in accordance with any of the preceding claims, ***characterized* by** the fact that the casing (2) is made of polyester.

6. Device (1) for monitoring and managing at least one set of elements constituting a set of batteries in accordance with any of the preceding claims, ***characterized* by** the fact that the casing (2) takes the form of two compartments (3, 4) between which are positioned a fire-and-explosion-proof seal (6) and the polymer epoxide (13) forming a capsule.
